# EUROPEAN PATENT APPLICATION

(11) **EP 2 204 817 A1**
(43) Date of publication of application: **07.07.2010**
(21) Application number: 09180990.5
(22) Date of filing: 30.12.2009
(51) Int. Cl.: G11C 16/02, G11C 7/18, G11C 13/02, G11C 8/08, G11C 8/14

(54) **Non-volatile memory with ovonic threshold switches**

(30) Priority: 30.12.2008 US 346700
(71) Applicant: STMicroelectronics Srl, 20041 Agrate Brianza (MB) (IT)
(72) Inventor: Kau, Derchang, Cupertino, CA 95014 (US); Atwood, Greg, Los Gatos, CA 95030 (US); Spadini, Gianpaolo, Santa Clara, CA 95054 (US)
(74) Representative: Pezzoli, Ennio

(57) **Abstract**

A memory device is disclosed. The memory device includes a plurality of memory cells being arranged in a matrix having a plurality of rows and a plurality of columns. Each memory cell includes a storage element and a selector for selecting the corresponding storage element during a reading operation or a programming operation. The memory device further includes a plurality of row lines each one for selecting the memory cells of a corresponding row and a plurality of column lines each one for selecting the memory cells of a corresponding column. The memory device further includes for each line among the row lines and/or the column lines a respective set of local lines each one for selecting a group of memory cells of the corresponding line, and a respective set of selection elements each one for selecting a corresponding local line of the set in response to the selection of the respective line.

## Description

The present disclosure relates to the integrated memories field. Specifically, the present disclosure relates to a non-volatile memory device; more particularly, the present disclosure regards a phase change memory device.

Different types of memory devices have been proposed in the last years. For example, an ovonic or phase-change memory (PCM) is a non-volatile memory exploiting the properties of a material that can be reversibly switched between an amorphous phase and a crystalline phase, such as a chalcogenide alloy. A PCM could be characterized as an E2PROM because it is non-volatile and electrically alterable. The phase-change material exhibits different electrical characteristics depending on its phase, each one representing a corresponding logic value. An example of a phase-change memory is described in US-A-5,166,758.

Typically, the memory device includes a matrix of memory cells, each one consisting of a storage element connected in series to an access selector. During a reading or programming operation on the memory device, the selectors are suitably biased so as to allow accessing the corresponding storage elements.

A solution known in the art for implementing those selectors is that of using bipolar elements, such as diodes or BJT transistors. An advantage provided by said solution is that a bipolar selector is capable of sustaining the high current that flows through the corresponding storage element during a programming operation. A drawback of this solution is that the bipolar element exhibits a high leakage current when reverse biased.

In order to avoid the drawbacks referred above, the selectors are commonly implemented with MOS transistors (and especially NMOS transistors). However, in this case each NMOS transistor must be quite wide in order to sustain the high current that flows through the corresponding storage element during a programming operation. This causes a waste of area in a chip of semiconductor material wherein the memory device is typically integrated.

A solution known in the art that goes in a different direction provides to implement the selectors with so-called ovonic threshold switches (OTS). An OTS is a switch made of chalcogenide, which may be brought from a highly resistive state to a conductive state if the voltage developed across the OTS reaches a switching threshold voltage value. Particularly, as soon as said voltage reaches the value of the switching threshold voltage, the OTS switches to conductive state, and the voltage developed thereacross rapidly drops to a holding voltage. In this conductive state, the voltage between the terminals of the OTS remains very close to this holding voltage almost regardless of the current flowing through the OTS, the resistance of the OTS being very low in the conductive state. The OTS remains in this conductive state until the current flowing therethrough is reduced below a holding current. An OTS is capable of sustaining relatively high currents.

A further advantage of said solution consists in that, unlike the selectors made of semiconductor transistors or diodes, an OTS does not require to be integrated into a semiconductor layer comprising active regions. Therefore, it is possible to vertically pile the memory cells in stacked layers, avoiding to waste silicon area in the chip without greatly increasing the cost of the manufacturing process.

However, employing OTS as selectors in a phase-change memory may be risky, since when a memory cell is selected, possible current spikes may occur, which stress the storage element of the cell and possibly provoke undesired spurious programming.

Particularly, a memory cell of such type, i.e., consisting of a storage element connected in series to an access selector, is conventionally connected between a respective bit line and a respective word line. In order to select the memory cell for programming or reading its storage element, the bit line and word line associated therewith are biased so that the respective OTS is switched to the conductive state. In detail, according to a known solution, the word line associated with the memory cell is brought to a low voltage- such as the ground voltage -, while the bit line is brought to a voltage sufficiently high to switch the OTS to the conductive state, i.e., in such a way that the terminals of the OTS have a voltage difference at least equal to the switching threshold voltage value. For example, the bit line is connected to a current generator which provides a predetermined current for charging the parasitic capacitance associated with the bit line itself. When the voltage of the bit line reaches a sufficiently high value, the OTS switches to the conductive state, with its resistance that falls abruptly. In this way, the charge stored in the parasitic capacitance associated with the bit line is shared with the parasitic capacitance associated with the word line. Since the parasitic capacitance associated with a typical word line is in general large, depending on the length of the word line itself and on the number of memory cells connected thereto, this charge sharing generates a relatively large current spike that crosses both the OTS and the storage element. As already mentioned, said current spike its capable of stressing the storage element of the cell and possibly provoking undesired spurious programming of the storage element.

In view of the above the Applicant has tackled the problem of how to avoid (or at least reduce) the occurrence of current spikes flowing across the storage element of a memory cell comprising an OTS selector during the selection of the memory cell itself.

Particularly, the present invention provides a solution as set out in the independent claims. Advantageous embodiments of the invention are described in the dependent claims.

More specifically, an aspect of the present invention provides a memory device. The memory device includes a plurality of memory cells being arranged in a matrix having a plurality of rows and a plurality of columns. Each memory cell includes a storage element and a selector for selecting the corresponding storage element during a reading operation or a programming operation. The memory device further includes a plurality of row lines each one for selecting the memory cells of a corresponding row and a plurality of column lines each one for selecting the memory cells of a corresponding column. The memory device further includes for each line among the row lines and/or the column lines a respective set of local lines each one for selecting a group of memory cells of the corresponding line, and a respective set of selection elements each one for selecting a corresponding local line of the set in response to the selection of the respective line.

Another aspect of the present invention provides a corresponding method.

A still further aspect provides for an electronic system.

The invention itself, as well as further features and the advantages thereof, will be best understood with reference to the following detailed description, given purely by way of a non-restrictive indication, to be read in conjunction with the accompanying drawings. Particularly:
Figure 1 schematically illustrates a phase-change memory device according to an embodiment of the present invention;
Figure 2 schematically illustrates a phase-change memory device according to a further embodiment of the present invention;
Figures 3A - 3C schematically show different layout implementations of the memory device of Figure 1 and Figure 2 according to various embodiments of the present invention; and
Figure 4 schematically illustrates a portion of an electronic system according to one embodiment of the present invention.

In the following, a solution according to exemplary and non-limitative embodiments of the present invention will be presented and described in detail. Those skilled in the art will however recognize that several modifications to the described embodiments are possible, and that the present disclosure can be embodied in different ways.

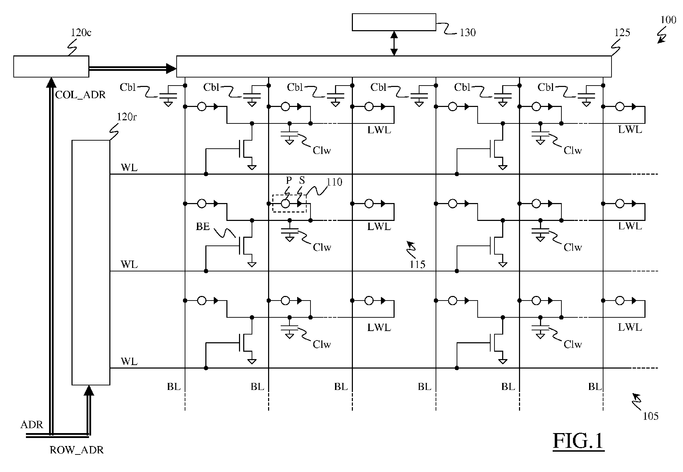

With reference in particular to Figure 1, a phase change memory device 100 is shown. The memory device 100 includes a matrix 105 of memory cells 110 arranged in rows and columns. Each memory cell 110 is formed by a storage element P having a programmable resistivity; the storage element P is connected in series to an access selector S.

Each storage element P is made of a phase-change material; typically, the phase-change material consists of a chalcogenide (such as an alloy Ge2Sb2Te5). The phase-change material can be reversibly switched between a generally amorphous, disordered phase and a generally crystalline, high ordered phase. The two phases of the material exhibit different electrical characteristics; particularly, the material in the amorphous phase has a high resistivity (defining a reset state associated with a first logic value, for example, 0), whereas the material in the crystalline phase has a low resistivity (defining a set state associated with a second logic value, for example, 1).

Without descending to particulars well known in the art, the phase of the material is stable below a predefined temperature (such as 150°C). The phase can be changed by heating the material over that temperature. For this purpose, a voltage higher than a corresponding phase-change value Vpc is applied to the storage element P; this voltage causes a current to flow through a resistive element (or heater) in contact with the phase-change material, which element heats by the Joule effect and then raises the temperature of the change-phase material accordingly. If the storage element P is brought over a nucleation temperature (such as 200°C) and kept there for enough time, the change-phase material becomes crystalline; conversely, if the storage element P is brought over a higher melting temperature (such as 600°C) and then cooled rapidly, the change-phase material becomes amorphous. The state of the storage element P is detected by applying a reading voltage (lower than the phase-change value Vpc, so as not to affect the phase of the material). The resulting current flowing through the storage element P is a signature of the resistivity of the material and then of its phase.

Each selector S is an OTS made of a phase-change material, such as chalcogenide, which may be switched from a highly resistive state - in which the material has a relatively high resistivity - to a conductive state - wherein the material has a relatively low resistivity. Unlike the storage element P, both in the highly resistive and in the conductive state, the material forming the S always remains in the amorphous phase. The selector S may be switched from the highly resistive state (also referred to as "off state") to the conductive state (also referred to as "on state"), by applying a voltage higher than a corresponding switching threshold voltage Vth. As soon as a voltage of such value is applied to the selector S, the selector S switches to the conductive state, and the voltage thereacross rapidly drops to a lower voltage, referred to as holding voltage Vh. In the conductive state, the voltage developed across the selector S remains very close to the holding voltage Vh almost regardless of the current flowing through the selector S until said current is reduced below a certain value referred to as holding current Ih.

The memory device 100 further includes a bit line BL for each column of the matrix 105, and a global word line WL for each row thereof.

According to an embodiment of the present invention, each global word line WL is associated with a respective set of m local word lines LWL. In each row of the matrix 105, the memory cells 110 are grouped in m cell packets 115, each one including a number n of memory cells 110 and being associated with a respective local word line LWL. The storage elements P forming the memory cells 110 of each column have a first terminal connected to the corresponding bit line BL. A second terminal of each storage element P is connected to a terminal of the respective selector S; the selectors S of the memory cells 110 belonging to a generic cell packet 115 have another terminal that is connected to the local word line LWL associated with the cell packet 115.

According to an embodiment of the present invention, each local word line LWL is configured to be selectively biased with a reference voltage, such as the ground voltage, by means of a respective bias element BE; the bias element BE is configured to be driven through the global word line WL that is associated with said local word line LWL. For example, the bias element BE may be a transistor, such as an n-channel MOSFET having a drain terminal connected to the local word line LWL, a source terminal connected to a terminal providing the ground voltage, and a gate terminal connected to the global word line WL associated with the local word line LWL. The concepts of the present disclosure can be applied to cases in which the bias elements BE are different from a MOSFET; for example, similar considerations apply to bias elements BE implemented using bipolar transistors.

The memory device 100 simultaneously processes a word consisting of a specific number of bits, for example equal to m. The bits of each word are stored in memory cells 110 belonging to a same respective row of the matrix 105; for example, each bit of a word may be stored in a respective memory cell 100 of each cell packet 115 included in the row. For this purpose, the bit lines BL of the matrix 105 are grouped into a plurality of subsets, each one for a bit of the words; for example, the number of said subsets may correspond to the number m of cell packets 115 included in a row of the matrix 105.

Each word is identified by an address ADR. A portion of the address ADR (COL_ADR) is provided to a column decoder 120c. The column decoder 120c drives a multiplexer 125, which selects a bit line BL in each subset. The multiplexer 125 interfaces with a read/program unit 130; the read/program unit 130 includes all the components (such as sense amplifiers, comparators, charge pumps, reference cells, pulse generators, and the like), which are used to program the selected storage elements P or to read their values. Another portion of the address ADR (ROW_ADR) is provided to a row decoder 120r, which accordingly selects a specific global word line WL.

In the following of the present description will be described how the memory cells 110 can be accessed for being processed (either for being read or programmed) according to an embodiment.

Based on the row address ROW_ADD, the row decoder 120r selects a specific row of the matrix 105 by biasing a corresponding global word line WL to a row selection voltage Vrs. The row selection voltage Vrs is sufficiently high to activate the bias elements BE associated with the selected global word line WL, so as to brought the corresponding local word lines LWL to the ground voltage. The other (unselected) global word lines WL are instead kept at a lower voltage, for example at the ground voltage, so that the bias elements BE associated therewith are off. In this condition, the (possible) charge stored in the parasitic capacitances associated with the local word lines LWL - identified in figure with the reference Clw - is discharged toward ground.

Moreover, according to the column address COL_ADR, the column decoder 120c drives the multiplexer 125, in such a way that the read/program unit 130 selects a bit line BL in each subset, i.e., one bit line BL per cell packet 115 of the selected row. Particularly, the selected bit lines BL are connected to the read/program unit 130 for being brought to a voltage sufficiently high to cause the switching of the associated selectors S to the conductive state, i.e., in such a way the voltage developed across the selectors S is at least equal to the switching threshold voltage Vth. For this purpose, the parasitic capacitances associated with the selected bit lines BL - depicted in figure with the reference Cbl - are charged by means of proper current generators (not shown in the figure) included in the read/program unit 130.

As long as the voltage difference between the selected bit lines BL and the corresponding selected local word lines LWL is such that the voltage developed across the selectors S is lower than the switching threshold voltage Vth, the selectors S are in the highly resistive state. In this condition, basically no current flows through the storage elements P. When the voltage of the selected bit lines BL reaches a value such that the voltage developed across the selectors S is equal to the switching threshold voltage Vth, the selectors S switch to the conductive state, and current starts to flow from the read/program unit 130 to ground through the paths formed by the respective storage elements P, selectors S and bias elements BE.

As soon as the selectors S switch to the conductive state, the charge that was previously stored in the bit line capacitances Cbl is rapidly redistributed between the bit line capacitances Cbl and the local word line capacitances Clw. As already mentioned in the introduction of the present document, because of the charge redistribution between the bit line capacitances Cbl and the local word line capacitances Clw, a current spike arises in the current flowing through the storage elements P.

However, unlike the known solutions, wherein said current spikes arise due to the redistribution between the bit line capacitances and the parasitic capacitances associated with the global word lines, in the proposed solution said current spikes are strongly reduced. Indeed, in the proposed solution the amount of charge that is redistributed is lower, because the parasitic capacitances Clw associated with the local word lines LWL are decidedly lower than the ones associated with the global word lines WL. In fact, the local word lines LWL are shorter than the global word lines WL and are connected to fewer memory cells 110.

Without entering into excessive details, well known to those skilled in the art, once the addressed memory cells 110 are selected as previously described, the read/program unit 130 may bias the selected bit lines BL according to the desired operation to be performed. For example, if a memory cell 110 has to be reset, the corresponding bit line BL is biased in such a way to provide a high current pulse of relatively short length to the storage element P; if instead the memory cell 110 has to be set, the bit line BL is biased in such a way to provide a lower current pulse of higher length to the storage element P, and so on.

According to an embodiment of the present invention, the current spikes that arise during the switching of the selectors S may be further reduced by properly controlling the bias elements BE in such a way to limit the current drained thereby. Indeed, the only way said spikes of current are capable of reaching the ground is through the respective bias elements BE. Since the current that can be drained by the bias elements BE depends on the row selection voltage Vrs provided to the gate terminal of the bias elements BE, the current spikes may be reduced by accordingly reducing the value of said row selection voltage Vrs during the selection of the memory cells 110. However, in order to correctly bring the local word lines LWL to the ground voltage, the value of the row selection voltage Vrs has to be sufficiently high to activate the bias elements BE. For example, a good compromise that allows to limit the current spikes and correctly bring the local word lines LWL to the ground voltage may be setting the selection voltage Vrs to a value slightly higher than the threshold voltage of the bias elements BE during the selection of the memory cells 100.

According to an embodiment of the present invention, once the selectors S have been switched to the conductive state, and the effects of the charge redistribution have been limited by setting the selection voltage Vrs to a relatively low value, the selection voltage Vrs may be raised to a higher value. In this way, the bias elements BE become able to drain the high currents used to perform correctly the programming operations on the selected memory cells 110. In other words, the value of the selection voltage Vrs may be dynamically varied by the row decoder 120r in such a way to assume a low value during the selection of the memory cells 110, and a high value during the programming of said selected memory cells 110.

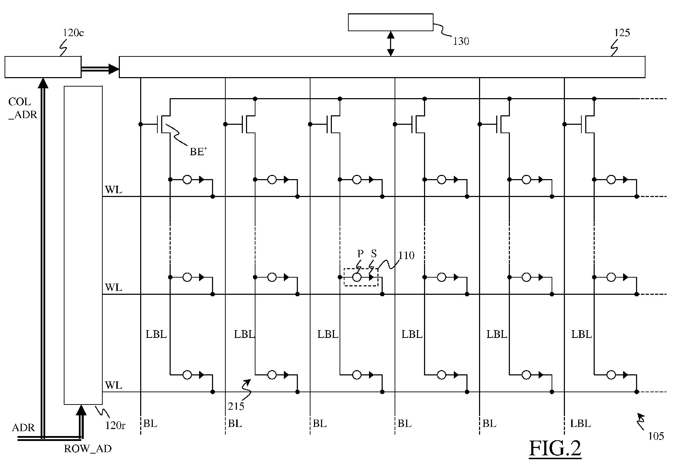

According to a further embodiment of the present invention, instead of having the memory cells 110 that are grouped by rows in packets 115 coupled to respective local word lines LWL, the memory cells 110 may be grouped by columns, as illustrated in Figure 2.

Particularly, according to this embodiment each bit line BL is associated with a respective set of p local bit lines LBL. In each column of the matrix 105, the memory cells 110 are grouped in p cell packets 215, each one including a number q of memory cells 110 and being associated with a respective local bit line LBL. The storage elements P forming the memory cells 110 belonging to a generic cell packet 215 have a first terminal connected to the corresponding local bit line LBL. A second terminal of each storage element P is connected to a terminal of the respective selector S; the selectors S of the memory cells 110 of a same row have another terminal that is connected to a corresponding word line WL.

In a way similar to the arrangement of Figure 1, each local bit line LBL is associated with a respective bias element BE', which is configured to be driven through the bit line BL that is associated with said local bit line LBL. Without entering into excessive details, the occurrence of undesired spikes in the currents flowing trough the storage elements P is limited in a same way as the memory device illustrated in Figure 1. In this case, however, the amount of charge that is redistributed during the switching of the selectors S is reduced because the parasitic capacitances associated with the bit lines LBL are low. Moreover, even in this case, the current spikes that may arise during the switching of the selectors S may be further reduced by properly controlling the bias elements BE' in such a way to limit the current drained thereby.

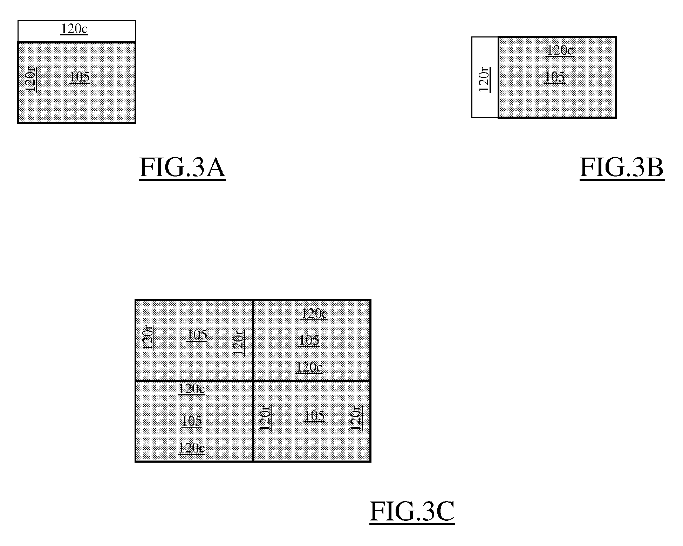

Figures 3A, 3B and 3C schematically show possible layout implementations of the memory device 100 according to various embodiments of the present invention.

As already mentioned in the introduction of the present document, since the selectors S of the memory cells 110 do not require to be integrated into a semiconductor layer comprising active regions, the matrix 105 of memory cells 110 may be formed in a chip layer that overtops the chip layer wherein the decoders and multiplexers are integrated. This allows to save silicon area in the chip integrating the memory device 100.

In the planar view shown in Figure 3A, the row decoder 120r is positioned under the matrix 105 of memory cells 110, while in the planar view shown in Figure 3B, it is the column decoder 120c that is positioned under the matrix 105 of memory cells 110. In both cases, the bias elements BE or BE' may be formed in the same chip layer that includes the row decoder 120r and the column decoder 120c. In case the matrix 105 of memory cells 110 is arranged in two or more vertically stacked layer, each bias element BE, BE' - formed in the same chip layer that includes the row decoder 120r and the column decoder 120c - may be associated with a respective packet 115, 215 of memory cells 110 formed in each one of said stacked layers.

In order to further improve the saving of silicon area, the memory device 100 may be implemented using both the implementations of the Figures 3A and 3B arranged according to a checker pattern, as illustrated in the planar view shown in Figure 3C. Particularly, the arrangement of Figure 3C consists of a plurality of memory tiles, each one comprising a corresponding matrix 105 of memory cells 110 connected to a respective row decoder 120r and a respective column decoder 120c; by alternating the arrangement of Figure 3A with the one of Figure 3B, it is possible to position all the row decoders 120r and the column decoders 120c under the matrixes 105 of memory cells 110.

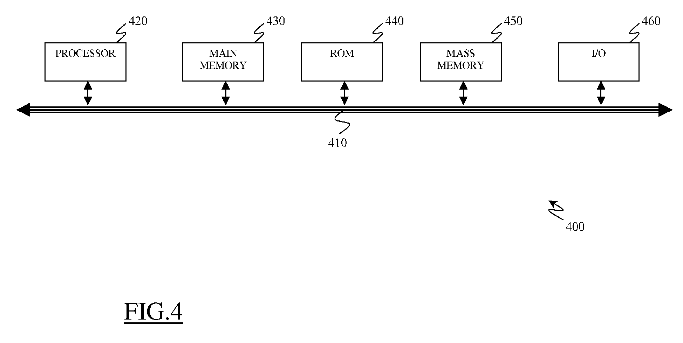

Figure 4 schematically illustrates a portion of an exemplary electronic system 400 in which the solution according to an embodiment of the present invention can be applied. The electronic system 400 may be for example a computer, a personal digital assistant (PDA), a laptop or portable computer, a digital music player, a digital camera, or other devices that may be configured to exploit an integrated non-volatile memory device.

The electronic system 400 is formed by several units that are connected in parallel to a system or communication bus 410 (with a structure that is suitably scaled according to the actual function of the system 400). In detail, one or more processors 420 control operation of the system 400; a main memory 430 is directly used as a working memory by the processors 420, and a ROM 440 stores basic code for a bootstrap of the system 400. Moreover, the system 400 is provided with a mass memory 450 for storing data and programs, and input/output units 460 for receiving/providing data from/to the outside.

The system 400 may exploit the advantages of the proposed solution by implementing the ROM 440 and/or the mass memory 450 with at least one non-volatile memory device such as the memory device 100 discussed herein.

Naturally, in order to satisfy local and specific requirements, a person skilled in the art may apply to the solution described above many logical and/or physical modifications and alterations. More specifically, although the present invention has been described with a certain degree of particularity with reference to preferred embodiment(s) thereof, it should be understood that various omissions, substitutions and changes in the form and details as well as other embodiments are possible. Particularly, the proposed solution may even be practiced without the specific details (such as the numerical examples) set forth in the preceding description to provide a more thorough understanding thereof; conversely, well-known features may have been omitted or simplified in order not to obscure the description with unnecessary particulars. Moreover, it is expressly intended that specific elements and/or method steps described in connection with any disclosed embodiment may be incorporated in any other embodiment as a matter of general design choice.

## Claims

1. A memory device including a plurality of memory cells being arranged in a matrix having a plurality of rows and a plurality of columns, wherein each memory cell includes a storage element and a selector for selecting the corresponding storage element during a reading operation or a programming operation, the memory device further including a plurality of row lines each one for selecting the memory cells of a corresponding row and a plurality of column lines each one for selecting the memory cells of a corresponding column, wherein:
the memory device further includes for each line among the row lines and/or the column lines a respective set of local lines each one for selecting a group of memory cells of the corresponding line, and a respective set of selection elements each one for selecting a corresponding local line of the set in response to the selection of the respective line.

2. The memory device of claim 1, wherein each selection element is adapted to bias the corresponding local line for activating at least one selector of the group of memory cells in response to the selection of the respective line.

3. The memory device of claim 2, wherein each selection element is a controlled switch having a first conduction terminal connected to the corresponding local line, a second conduction element for receiving a bias voltage and a control terminal connected to the respective line.

4. The memory device of claim 3, wherein each controlled switch is adapted to set a current flowing across the memory cells of the group whose selectors have to be activated based on a voltage of the respective line.

5. The memory device of claim 4, wherein each controlled switch is adapted to:
- set said current to a first value during the activation of said selectors, and
- set said current to a second value higher than the first value during a programming operation of the storage elements.

6. The memory device of any one among the preceding claims, wherein the row lines are word lines and the column lines are bit lines.

7. The memory device of claim 6, wherein the local lines are local word lines each one for selecting a group of memory cells of a respective word line.

8. The memory device of claim 6, wherein the local lines are local bit lines each one for selecting a group of memory cells of a respective bit line.

9. The memory device of any one among the preceding claims, wherein said storage element is a phase-change storage element and said selector is an ovonic threshold switch.

10. The memory device of any one among the preceding claims, wherein the selection elements are transistors.

11. In a memory device including a plurality of memory cells being arranged in a matrix having a plurality of rows and a plurality of columns, wherein each memory cell includes a storage element and a selector for selecting the corresponding storage element during a reading operation or a programming operation, the memory device further including a plurality of row lines each one for selecting the memory cells of a corresponding row and a plurality of column lines each one for selecting the memory cells of a corresponding column, the memory device further including for each line among the row lines and/or the column lines a respective set of local lines, a method comprising:
- selecting a line;
- selecting local lines of the respective selected line for selecting a group of memory cells of the corresponding line.

12. An electronic system, including:
- at least one processor coupled with a main memory used as working memory of said at least one processor;
- input/output units for receiving and providing data; and
- at least one mass memory for storing data and/or instructions to be used by the at least one processor, wherein at least one among said main memory and said at least one mass memory comprises a memory device that includes:
a plurality of memory cells being arranged in a matrix having a plurality of rows and a plurality of columns, wherein each memory cell includes a storage element and a selector for selecting the corresponding storage element during a reading operation or a programming operation, the memory device further including a plurality of row lines each one for selecting the memory cells of a corresponding row and a plurality of column lines each one for selecting the memory cells of a corresponding column, wherein:
the memory device further includes for each line among the row lines and/or the column lines a respective set of local lines each one for selecting a group of memory cells of the corresponding line, and a respective set of selection elements each one for selecting a corresponding local line of the set in response to the selection of the respective line.
